# EUROPEAN PATENT APPLICATION

(11) **EP 2 224 500 A2**
(43) Date of publication of application: **01.09.2010**
(21) Application number: 10160795.0
(22) Date of filing: 25.07.2003
(51) Int. Cl.: H01L 33/00, H01S 5/34

(54) **Controlled electro-optical device**

(62) Divisional of application: 03254642.6
(71) Applicant: Hitachi Ltd., Tokyo 101-8010 (JP)
(72) Inventor: Wunderlich, Jörg, Cambridge CB5 8DR (GB); Kästner, Bernd, Cambridge CB2 15T (GB); Williams, David, Cambridge CB2 1NN (GB); Hasko, David, Cambridge CB6 3SU (GB)
(74) Representative: Read, Matthew Charles

(57) **Abstract**

A controllable electro-optical device comprising a substrate (1), a layer structure (2-6) on the substrate to provide first and second essentially two dimensional conductive regions (10, 11) of 2DEG and 2DHG with an edge region (12) at which electrons and holes can combine to produce photons, a bias electrode structure (7, 8) for applying a bias voltage to the conductive regions for biasing the charge carriers to the edge region, and a control structure (14) additional to the bias electrode structure, for controlling the passage of charge carriers to the edge region. The control structure (14) produces a time correlated charge carrier flow and may control the charge carrier spin. Also the control structure may comprise an essentially one dimensional ballistic charge carrier transport device.

## Description

This invention relates to a controlled electro-optical device in which photons can be emitted with controlled characteristics.

Optical radiation can be produced in a light emitting diode, in which a p-n junction is biased so that electrons and holes combine to create photons.

Recently a lateral p-n junction has been proposed in an AlGaAs stepped semiconductor layer structure. Reference is directed to "Nanoscale lateral light emitting p-n junctions in AlGaAsAs/GaAs, Microelectronics Engineering, Elsevier Publishers B.V. Vol. 67-68, June 2003-06, pages 797-802, XP0044289952 ISSN: 0167-9317 and also to B. Kaestner, D. G. Hasko and D. A. Williams Jpn, J. Appl. Phys. 41 2513(2003). The device includes a two dimensional hole gas (2DHG) and two dimensional electron gas (2DEG) laterally disposed on opposite sides of a nanometre scale step in the structure. The junction is biased so that electrons and holes from the 2DHG and 2DEG combine at the step in the structure to emit photons.

The present invention is directed to improvements to such a junction in which controlled photon emission occurs, for use in devices such as charge carrier spin state detectors for spintronic devices, single photon emitters and spintronic devices in which photons with a particular polarisation are created.

Broadly stated the invention provides a controllable electro-optical device comprising a substrate, a layer structure on the substrate to provide first and second essentially two dimensional conductive regions overlying the substrate for charge carriers of opposite polarity, with an edge region at which the charge carriers can combine to produce photons, a bias electrode structure for applying a bias voltage to the conductive regions for biasing charge carriers therein to the edge region, and a control structure additional to said bias electrode structure, operable to correlate, in time, the passage of charge carriers that are biased by the bias voltage applied to the bias electrode structure to pass to the edge region, so as to control production of the photons in respect of their correlation in time.

The control structure may comprise a turnstile, an electron pump or a series of single electron boxes.

The control structure may be operable to control the spin of the charge carriers such that the polarisation of the emitted photons is dependent on the charge carrier spin.

Furthermore, the control structure may comprise at least one quantum dot through which the charge carriers pass and the quantum dot may include a magnetic particle in the quantum dot for spin polarising the charge carriers.

The device may be used to detect the spin of charge carriers. For example a charge carrier source may supply charge carriers to the control structure with a predetermined spin characteristic, which are spin-filtered by the control structure, and a detector detects the resulting photons, which are produced as a function of the charge carrier spin.

Also an essentially one dimensional ballistic charge carrier transport device can be used for the control structure.

In order that the invention may be more fully understood embodiments thereof will now be described by way of example with reference to the accompanying drawings in which:
Figure 1 is a schematic cross sectional view of a controllable optical device in accordance with the invention, with its control structure illustrated schematically in dotted outline;
Figure 2 is a plan view corresponding to Figure 1, in which the control structure comprises a series of electron boxes;
Figures 3a-d illustrate process steps for fabricating the device of Figure 2;
Figure 4 is a schematic plan view of an optical device corresponding to Figure 1, in which the control structure comprises a turnstile device;
Figure 5 is a plan view of a device corresponding to Figure 1, in which the control structure comprises an electron pump;
Figure 6 is a plan view of a device corresponding to Figure 1, in which the control structure comprises a series of quantum dots with one of them containing a ferromagnetic particle for spin polarising electrons;
Figure 7 is a sectional view of the device of Figure 6 taken along the line A-A' illustrating the magnetic field produced by the ferromagnetic particle;
Figure 8 is a schematic plan view of a device corresponding to Figure 1, in which the control structure comprises a quantum dot operable as a spin filter, containing a ferromagnetic particle for producing spin polarisation;
Figures 9a-9b are schematic illustrations of an alternative form of spin filter for use in the device of Figure 8 in which the local magnetic field applied to electrons can be modulated by the magnetisation state of ferromagnetic electrodes;
Figure 10 is a schematic plan view of another device according to the invention in which the control structure comprises a mesoscopic Aharanov-Bohm spin switch, and
Figure 11 is a schematic plan view of another device according to the invention in which the control structure comprises a stub filter.

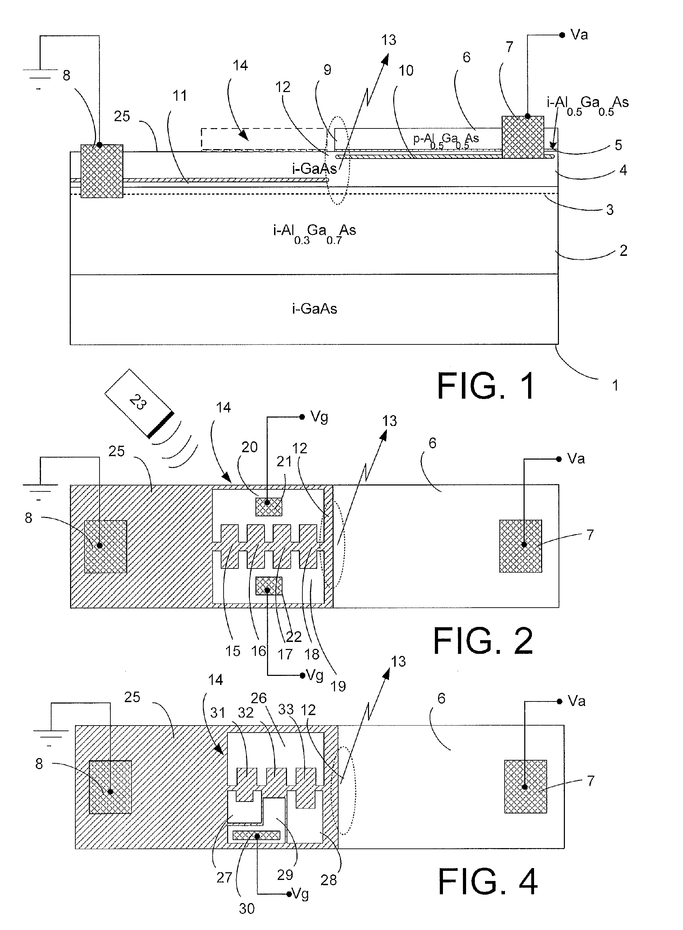

Referring to Figure 1, the optical device comprises a mesa formed on a semiinsulating i-GaAs substrate 1. The device structure was prepared using molecular beam epitaxy (MBE). An i-Al_{0.3}Ga_{0.7}As layer 2 was grown to a thickness of approximately 300nm on the substrate 1 and provided with an n-type δ-doped upper region 3 (5 x 10¹²cm⁻²). The layer 2 is covered with a i-GaAs layer 4 to a thickness of approximately 90nm, a 3nm un-doped i-Al_{0.5}Ga_{0.5}As spacer layer 5, itself overlaid by a layer of Be-doped, p-type i-Al_{0.5}Ga_{0.5}As layer 6 to a thickness of 47nm with a doping level of approximately 8 x 10¹⁸cm⁻³.

A 5nm thick top layer of Be-doped GaAs (not shown) is provided in order to facilitate a formation of p-type Ohmic contacts made of a conventional Au/Zn alloy.

The layers 5, 6 are selectively etched to provide a step edge 9. The layers 5, 6 combine to produce a 2DHG 10 underlying the p-doped layer 6 in the i-GaAs layer 4. Similarly, the layer 4 includes a 2DEG region 11 produced by the δ-doping 3. The 2DEG region 11 ceases at the step edge 9 since the 2DEG region 11 becomes fully depleted underneath the p-type layer 6. The Ohmic contacts 7, 8 provide electrical connections to the 2DHG region 10 and the 2DEG region 11. In use, when a forward bias voltage Vₐ is applied between the contacts 7, 8, charge carriers in the 2DHG and 2DEG regions 10, 11 combine in the layer 4, in the circled, dotted region 12. Thus, holes and electrons combine in the region 12 to emit photons 13. The device typically operates at a bias voltage Vₐ depending on the corresponding bandgap of the semiconductor material. In this example, where a GaAs material system is used, the bandgap energy is about 1.4eV at 4K, which leads to a voltage Vₐ of 1.4V.

A control structure 14 is formed from an etched portion of the layer 6 to control the passage of electrons in the 2DEG region 11 to the electron-hole combination region 12, so as to control the emission of photons. One example of the control structure 14 is shown in more detail in Figure 2. In this example, the control structure comprises a series of single electron boxes 15 - 18 that are defined between finger gate structures 19, 20 that receive a gate voltage V_{g}. The gate structures 19, 20 are formed by etching in a manner to be described hereinafter from a portion of the layer 6 and are provided with Ohmic contact regions 21, 22 to receive the gate voltage V_{g}. The gate voltage V_{g} applies a reverse bias to the finger gate structures 19, 20 and thereby produces depletion regions in the 2DEG region 11 corresponding to the geometry of the finger gate structures, so as to define the single electron boxes 15 - 18 in the 2DEG 11.

In use, the structure is irradiated with microwave radiation from the source 23 shown schematically.

Each of the electron boxes 15 - 18 is of the order of >100 nm and is capable at temperatures of the order of 4°K to retain individual electrons by means of the Coulomb blockade effect. Smaller structures can extend the working range of Coulomb blockade to higher temperatures. The fingers of the gate electrodes 20, 21 form a series of five tunnel barriers when a negative gate voltage V_{g} is applied and single electrons can be phase-locked by the microwave radiation from source 23 so as to tunnel from electron box to electron box 15 - 18 successively and then to the combination region 12 at the edge 9 of region 6, so as to produce a sequence of individual photons 13, phase-locked to the microwave radiation. Thus, the electron box configuration acts as a correlation device so as to produce a time-correlated stream of electrons for conversion into corresponding photons in the region 12.

The microwave radiation can be coupled inductively into the substrate for example using a coil terminating a microwave cable close to the substrate 1 of the device. Also, the capacitive coupling could be provided by means of small chip capacitors (not shown). For a further discussion of the operation of electron boxes, reference is directed to K.K. Likharev, N.S. Bakhvalov, G.S. Kazacha and S.I. Serdyukova, IEEE Trans. Magn. 25, 1436 (1989).

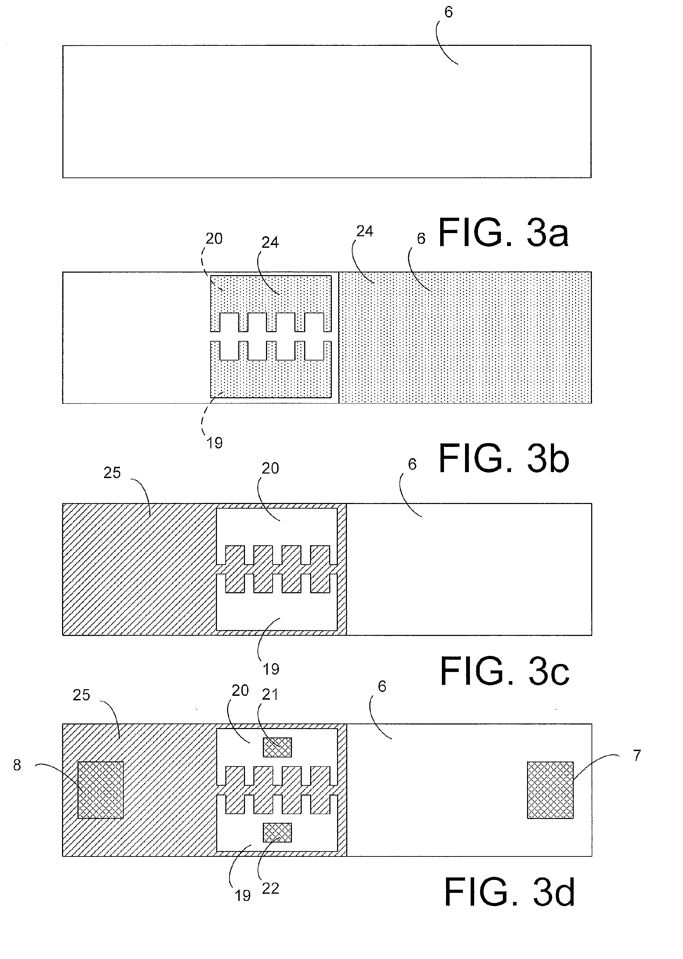

A method of fabricating the device of Figure 2 will now be described in more detail with reference to Figure 3.

Referring to Figure 3a, the previously described mesa is defined using conventional photolithography, in which a mask is overlaid on the layers 1 - 6 shown in Figure 1 and selective etching is carried out using the mask to define the mesa. A suitable etchant is H₃PO₄/H₂O₂. This results in a mesa structure as shown in Figure 3a with a continuous layer 6 on its uppermost surface.

Thereafter, an optical or electron beam resist 24 is spun onto the surface of the mesa, baked, exposed and developed to form regions 24 shown in Figure 3b corresponding to the stepped layer 6 shown in Figure 1 and the gate electrodes 19, 20. The mask can also be defined by a removable metal layers such as Al or Au.

The configuration is then wet etched in a two stage process. Firstly, a 25 second etch in H₂SO₄:H₂O₂:H₂O = 1:8:1000 at 25°C is performed to remove the bulk of the unmasked layer 6 and then a 10 second etch in HF is performed, which is etch stopped at exposed regions of the i-GaAs layer 4. The mask is then removed using acetone and the resulting configuration is shown in Figure 3c. The region that is etched by the aforementioned etching process is referenced 25.

Alternative etching procedures such as time controlled reactive etching, are also possible.

Then, conventional Ohmic contact metalisation is applied in regions 7, 8, 21 and 22 to provide the Ohmic contacts to the 2DHG, 2DEG and gate electrodes.

Figure 4 illustrates an alternative embodiment in which the control electrode structure 14 comprises a single electron turnstile. Turnstiles are known per se and described in H. Grabert and M. H. Devoret, eds. Single electron charge tunnelling: Coulomb Blockade phenomena in nanostructures. Chapter 3, NATO ASI Series, Plenum Press, New York, 1992. The turnstile of Figure 4 produces a time correlated stream of single electrons or packets of small numbers of electrons in the 2DEG region 11 of Figure 1, which are fed to the combination region 12 at the lateral junction between the 2DEG region 11 and 2DHG 10.

The turnstile comprises first, second and third floating electrodes 26, 27, 28, together with an electrode 29 that receives a cyclic gate voltage Vg through Ohmic contact 30. The electrodes define three quantum wells 31, 32 and 33 in the 2DEG region 11 that are separated by tunnel barriers, in a similar manner to the example of Figure 2.. The level of charge that can be accumulated in each of the quantum wells is limited by the Coulomb Blockade effect. By raising and lowering the voltage applied to the gate 29, an electron in quantum well 31 can be caused to tunnel into well 32 and after a subsequent potential change at gate 29, the electron can furthermore enter the well 33. In this way, electrons move in a time correlated fashion sequentially between the quantum wells 31, 32 and 33 and thence to the combination regions 12 to form photons by combination with holes in the 2DHG region. The photon production is thus time correlated to the single electron stream produced by the turnstile 14 in Figure 4.

It will be appreciated that the electrodes 26, 27, 28 and 29 can be fabricated from the layer 6 in accordance with the method described with reference to Figure 3, with the mask 24 being appropriately configured to define the turnstile electrodes. Similarly, the Ohmic contact 30 can be formed in the same way as contacts 7 and 8.

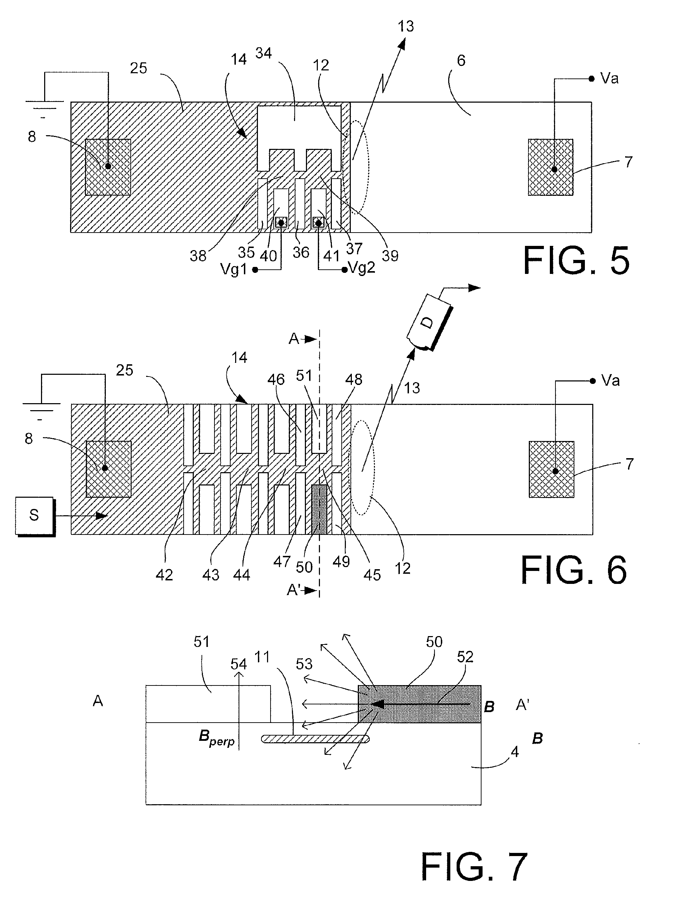

Referring now to Figure 5, an optical device with an alternative control structure 14 is shown, that comprises a single electron pump. Single electron pumps are known **per se** and reference is directed to H. Grabert et al **supra**. Single electron pumps can provide a time correlated supply of single electrons to the electron/hole recombination region 12 so as to produce a corresponding emission of time correlated photons. As shown in Figure 5, the electron pump consists of an electrode 34 which, in combination with electrodes 35, 36, 37 define first and second quantum wells 38, 39. The potential within the wells 38, 39 can be controlled by gate voltages V_{g1} and V_{g2} applied to electrodes 40, 41.

In use, a constant bias voltage Vₐ is applied between the Ohmic contacts 7, 8. Periodic signals of the same frequency but 90° phase difference are applied as the variable gate voltages V_{g1} and V_{g2}. In use, an electron tunnels through the barrier between the electrode 35 and electrode 34, into the quantum well 38. The level of charge in the well is limited by Coulomb Blockade as well known in the art. When the voltage V_{g1} is raised, the electron in well 38 is caused to tunnel through the barrier provided by electrode 36 and electrode 34, into the next well 39. Since the voltage V_{g2} is low in well 39, the charge can transfer from well 38 to well 39. During the next half cycle of the gate voltages V_{g1} V_{g2} the electron in well 39 is biased so as to tunnel through the barrier provided by electrode 37 and electrode 34 and as a result moves into the region 12 where the electron combines with a hole from the 2DHG region 10 so as to produce a corresponding photon 13. It will be understood that the wells 38, 39 deliver packets of small numbers of electrons to the recombination region 12. The packets may comprise solely of individual electron or a small group of them e.g. ten. Thus, time correlated packets of electrons are provided by the electron pump 14, thereby producing corresponding time correlated photons. It will be understood that the electrode structure shown in Figure 5 can be fabricated using the same techniques described with reference to Figure 3 but with the mask layer 24 patterned so to provide the electrodes 34 - 41 shown in Figure 5.

Further examples of the invention will now be described which employ a quantum dot in the control structure 14 to spin-filter electrons as they pass to the combination region 12. The photons 13 produced in the combination region have a circular polarisation which is dependent on the spin of the spin-filtered electrons that pass through the quantum dot. This general technique can be used in a number of different ways, for example to provide an optical output dependent on the spin of electrons in a so-called spintronic system, or as a spin modulator. Examples will now be described in more detail.

Referring to Figure 6 and 7, a device according to the invention is provided with a control structure 14 that uses a quantum dot as an electron spin filter. This can be used so that the device produces an optical output with an intensity dependent on the spin of electrons passing along it.

The control structure 14 comprises a series of four quantum dots 42, 43, 44 and 45 that are provided with tunnel barriers at their entrances and exits by pairs of electrodes. Correlated electron transfer between the quantum dots 42 - 45 can be achieved by any of the techniques previously described with reference to Figures 2, 4 or 5.

The quantum dot 45 will now be described in more detail. The dot includes first and second electrodes 46, 47 which provide a small gap between them constituting a tunnel barrier through which electrons can tunnel from previous dot 44. Similarly the dot includes electrodes 48, 49 which provide a corresponding exit tunnel barrier for electrons passing to the charge combination region 12. The dot 45 also includes electrodes 50 and 51. The tunnel barrier electrodes 46, 47, 48 and 49, together with the electrodes 51 may be fabricated in accordance with the techniques described with reference to Figure 3, from layer 6 by a suitable patterning technique. However, preferably, the electrodes are formed of a metal such as Al or an alloy thereof by conventional patterning and deposition techniques. In accordance with the invention, the electrode 50 is magnetic and performs the function of filtering the spin polarisation of electrons that pass through the well. Thus, the electrons that pass from well 45 to combine with holes in the charge combination region 12, may all have substantially the same spin polarisation. As a result, the polarisation of the emitted photons can be configured to be dependent upon the spin polarisation imparted by the dot 45 to the electrons that give rise to the photons. The magnetic particle 50 gives rise to a stray field 53 that has a component **B**ₚₑᵣₚ that is perpendicular to the plane of the substrate 1. It has been found that this field component controls the spin of the electrons in the dot 45, enabling the quantum dot to act as a spin filter such that the electrons that pass through it to the recombination region 12 substantially all have the same spin up or spin down polarisation.

In the charge combination region 12, the electrons with their particular spins combine with holes to produce photons and the emitted photons all have the same left or right hand circular polarisation dependent on the spin of the spin-filtered electrons from the quantum dot 45. An electrical photo detector D detects photons 13 from the combination region 12. In one possible use of the device, the spin of the electrons passing between the dots 42 - 44 may used to denote data in a so-called spintronics system, e.g. by circuits S (not shown) that supply electrons with particular spins to the 2DEG region 11. If the spin of the electrons aligns with the spin filtering direction of the spin filtering quantum dot 45, then a relatively large flow of electrons will occur through the spin filter to the combination region 12, but otherwise a small electron flow will occur. Thus, the rate at which photons are produced in the combination region 12 will depend on the spin of the electrons and so electrical output of the detector D is a function of the spin state of the electrons, and may be used as a data output. This arrangement has the advantage that only one of the dots needs to be configured as a spin filter to produce the desired optical output.

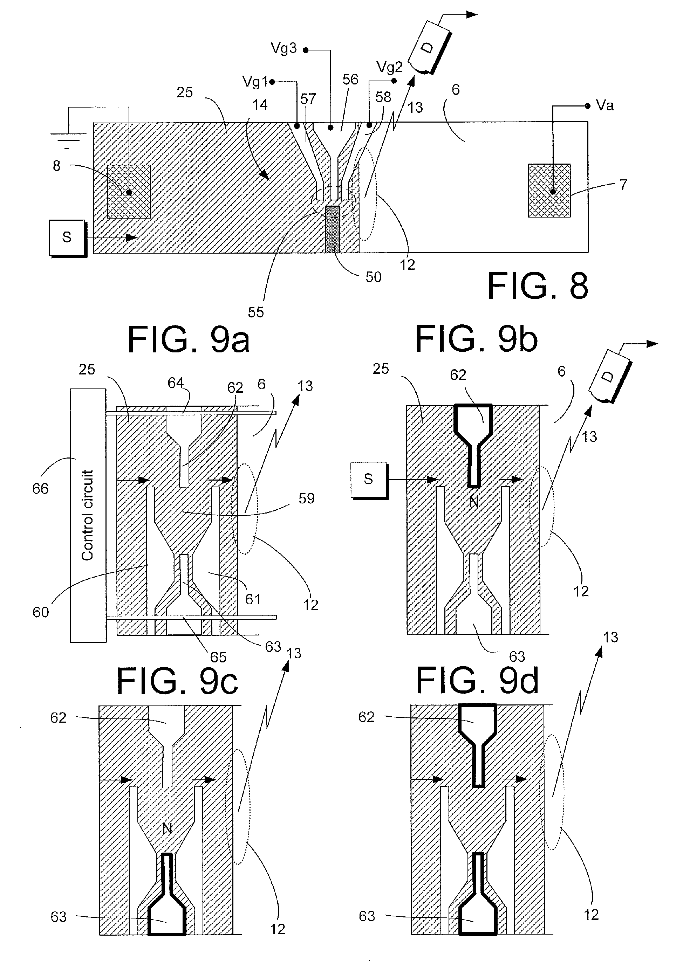

The spin filtering can be performed by a quantum dot without operating as a turnstile and an example which can be used to control electron spin and hence polarisation of the photons, is shown in detail in Figure 8. In this embodiment, the mesa structure is substantially the same as that shown in Figure 1 but the control structure 14 comprises a quantum dot 55 that is defined between a magnetic particle 50 having its easy axis in the plane of the device as previously described, together with a non-magnetic electrodes 56, 57 and 58 which may receive constant biases to define the quantum dot. The electrodes may be formed by conventional metallisation and patterning techniques known *per* se to those skilled in the art or may be formed in the manner described with reference to Figure 3. A source S supplies electrons with a predetermined spin from e.g. spintronics circuits (not shown) to the 2DEG region 11 in layer 25. The electrons are filtered as previously described with reference to Figures 6 & 7 and the detector D provides an output dependent on the rate at which the photons 13 are produced in the combination region 12, to provide an electrical output dependent on the spin of the electrons from source S.

The spin filtering technique can also be achieved without the use of the magnetic particle 50, which can be replaced by a non magnetic electrode so as to define the quantum dot. In this situation, an external in-plane magnetic field is applied (by means not shown) to produce the spin filtering by the quantum dot.

The quantum dot of Figure 8 can also be configured for use as a turnstile, in which case the electrode 56 receives a constant voltage bias V_{g3} and electrodes 57, 58 control the ingress and egress of single electrons to and from the quantum dot 55. The electrodes 57, 58 receive cyclic 90° phase shifted voltages V_{g1} and V_{g2}.

Figure 9 illustrates operation of an alternative magnetisable quantum dot for use as the control structure 14, in order to filter the spin of the electrons passing to the combination region 12. Referring to Figure 9a, the control structure 14 comprises a arrangement which operates in a generally similar manner to the arrangement of Figure 8. Quantum dot 59 is defined by two electrodes 60, 61 and two magnetisable electrodes 62, 63 which may be made from a patterned layer of cobalt is previously described. Electrical conductors, which may comprise printed circuit tracks 64, 65 can pass current over the magnetisable electrodes 62, 63 individually under the control of a modulator control circuit 66 shown schematically. The currents generate magnetic fields that have a component in the plane of the device to magnetise the magnetisable electrodes with a north or south magnetisation along their length, individually. Thus, electrons can pass in a through the quantum dot 59 to the charge carrier combination region 12 in the manner previously described, with their spin states being set in dependence upon the magnetisation of the magnetisable electrodes 62, 63. Four different states of field strength and hence polarisation can be produced depending on which of the electrodes 62, 63 are magnetised. The four states are set out in Table 1.

**Table 1**

| **State** | **Gate 62** | **Gate 63** | **B** | **Figure No.** |
|---|---|---|---|---|
| 1 | North | North | ++ | Fig. 9d |
| 2 | North | South | + | Fig. 9c |
| 3 | South | North | - | Fig. 9b |
| 4 | South | South | - - | Fig. 9a |

Thus the device of Figures 9a-d can be used to detect selectively at the detector D, one of four different electron spin states for electrons from the source S.

The devices described with reference to Figures 6 to 9 can also be operable as a photon source to provide photons with a predetermined spin based on the spin filtering direction of the electron spin filter. Also the device of Figure 9 can be used as a spin modulator for emitted photons. The invention therefore has application to opto-electronics to provide a charge to photon converter and to quantum cryptography so as to provide a single photon source with a controllable photon polarisation. In particular, the single photon source with controllable polarisation can be used for secure information transmission. The described devices can readily be incorporated into a resonator to produce directed emission of photons.

Many modification and variations of the described devices are possible. For example, improved efficiency may result from inverting the 2DEG and 2DHG layers 10, 11 so that the 2DEG layer lies above the 2DHG layer. Also, it may be desirable to include a control structure to provide correlated hole transfer in addition to or instead of the correlated electron transfer in the described example.

Furthermore, different material systems may be used. For example, with reference to Figure 1, AlₓGa₁₋ₓAs with x>0 may be used for region 4, instead of x=0 as described above. The condition is that x<0.4 for region 4 (to maintain light emission properties) and that x is larger in region 2 (3), 5 and 6 compared to region 4.

In addition, with the same condition for x with respect to regions 2 (3), 5 and 6 on one hand, and region 4 on the other hand, one may use the following III-V material systems, instead of A1ₓGa₁₋ₓAs:
In₁₋ₓAlₓAs (x=0...0.7)
InₓGaₓAs (x=0...1)
GaAsₓP₁₋ₓ (x=0...0.5)
Ga₁₋ₓAlₓSb (x=0...0.3)
InAs₁₋ₓPₓ (x=0..1)
AlₓGa₁₋ₓN (x=0...1)
In₁₋ₓGaₓN (x=0...1)

Also combinations of these systems are possible, as long as the bandgap of region 4 is smaller than the bandgap of regions 2 (3), 5 and 6.

The following II-VI system can also be used, with the same restriction on x, comparing regions 2 (3), 5 and 6 on one side and region 4 on the other side:
CdₓHg₁₋ₓSe
TeHg₁₋ₓCdₓ
Hg₁₋ₓZnₓSe
ZnₓCd₁₋ₓSe
ZnSₓSe₁₋ₓ
ZnsₓTe₁₋ₓ

A further approach according to the invention is to implement the carrier-control structure (turnstile, pump, etc.) into the un-etched region 6. No modification is needed for structures using surface gates. When side-gates are used, as per Figure 3, the mask fabrication will need to be modified. Previously, regions where side-gate is intended to be located has to be masked when the selective etch is performed. In contrast, when the control structure is in the uneteched region, areas, where the side-gate is intended to be located, have to be etched, i.e. not masked.

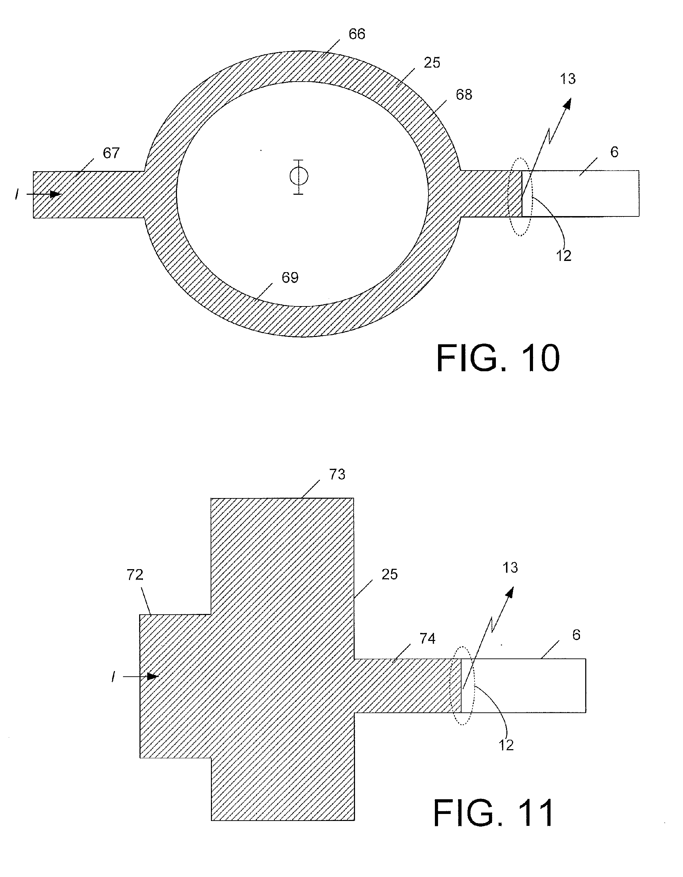

The invention can also be used with quantum wires and rings in the control structure 14, that make use of essentially one dimensional ballistic charge carrier transport properties in order to manipulate the spin, rather than the previously described quantum dots and wells. Referring to Figure 10, the mesa structure described with reference to Figure 1 is etched to provide a mesoscopic Aharonov-Bohm ring 66 by suitably etching away the layer 6 to provide a circular etched region 25 with a current input arm 67, first and second circular arms 68, 69 and an output arm 70 which connects to the unetched region 6 in order to provide the p-n junction between the 2DEG and 2DHG regions that constitutes the charge combination region 12. In use, electrons I enter through the input arm 67 and pass through arms 68, 69 to the output arm 70 through a magnetic field Φ. The electrons reaching the output arm 70 are imparted with a predetermined spin as a function of the applied magnetic field. Further operational details of the Aharonov-Bohm ring are described in Phys. Rev. Lett. 87, p256602, (2001). The electrons produce corresponding spin polarised photons 13 in the combination region 12, which can be processed as described previously with reference to the preceding examples of the invention.

Another example is shown in Figure 11, in which the mesa is etched to provide a ballistic transport stub tuner for use as the spin filter, as described in Appl. Phys. Lett. 80, 8, p1400. The etched region 25 defines a stub tuner region 71 that receives electrons I in an input arm 72, that pass to a tuning region 73 and then to an output arm 74 with a predetermined spin defined by the stub tuner. The electrons then combine with holes in the combination region 12 to produce photons 13 which are processed as previously described.

The actual dimensions of the devices shown in Figures 10 and 11 depend on the operational temperature, charge carrier density and mobility. In general, the devices need to be small enough and/or the operation temperature low enough to guarantee ballistic transport throughout the device.

## Claims

1. A controllable electro-optical device comprising a substrate (1), a layer structure (2-6) on the substrate to provide first and second essentially two dimensional conductive regions (10, 11) overlying the substrate for charge carriers of opposite polarity, with an edge region (9) at which the charge carriers can combine to produce photons (13), a bias electrode structure (7, 8) for applying a bias voltage to the conductive regions for biasing charge carriers therein to the edge region, **characterised by** a control structure (14) additional to said bias electrode structure, operable to correlate, in time, the passage of charge carriers that are biased by the bias voltage applied to the bias electrode structure to pass to the edge region, so as to control production of the photons in respect of their correlation in time.

2. A device according to claim 1 wherein the control structure comprises a turnstile (27-29).

3. A device according to claim 1 wherein the control structure comprises an electron pump (34-39).

4. A device according to any preceding claim wherein the control structure comprises a series of single electron boxes (15-19).

5. A device according to claim 4 including a microwave source (23) for inducing coherent charge carrier tunnelling between the boxes.

6. A device according to any preceding claim wherein the charge carriers comprise single electrons.

7. A device according to any preceding claim wherein the control structure (14) is operable to control the spin of the charge carriers such that the polarisation of the emitted photons is dependent on the charge carrier spin.

8. A device according to any preceding claim wherein the control structure comprises at least one quantum dot (38,39, 42-45) through which the charge carriers pass.

9. A device according to claim 8 including a magnetic particle (50) in the quantum dot for spin polarising the charge carriers.

10. A device according to claim 1 wherein the control structure comprises an essentially one dimensional ballistic charge carrier transport device.

11. A device according to any preceding claim including a detector (D) for detecting the photons.

12. A device according to any preceding claim including a charge carrier source (S) for supplying to the control structure charge carriers with a predetermined spin characteristic.
